# EUROPÄISCHE PATENTSCHRIFT

(11) **EP 0 282 078 B1**
(45) Veröffentlichungstag und Bekanntmachung des Hinweises auf die Patenterteilung: **16.06.1993**
(21) Anmeldenummer: 88103892.1
(22) Anmeldetag: 11.03.1988
(51) Int. Cl.: H05K 3/44, H05K 1/05

(54) **Verfahren zur Herstellung von Metallkerne enthaltenden elektrischen Leiterplatten und Basismaterial dafür**
Process for making an electrical-circuit board comprising a metal core and basic material for the same
Procédé de fabrication d'un circuit électrique comportant un noyau métallique et matériau de base utilisé

(30) Priorität: 12.03.1987 DE 3708000
(43) Veröffentlichungstag der Anmeldung: 14.09.1988
(73) Patentinhaber: ISOLA WERKE AG, D-52353 Düren (DE)
(72) Erfinder: Hartmann, Helmut, D-5166 Kreuzau-Bilstein (DE)
(74) Vertreter: TER MEER STEINMEISTER & PARTNER GbR

(56) Entgegenhaltungen:
- EP-A- 0 202 544
- DE-A- 2 739 494
- DE-A- 3 525 416
- US-A- 3 296 099
- US-A- 4 315 845

## Beschreibung

Gegenstand der Erfindung ist ein Verfahren zur Herstellung von elektrischen Leiterplatten mit einem Kern aus einem metallischen Werkstoff, durch Erzeugen der Isolierschicht auf der mit den erforderlichen Durchgangsbohrungen versehene Metallkernplatte unter Verwendung eines Pulverlacks und Ausbilden der Leiterzüge, sowie ein Basismaterial für solche elektrische Leiterplatten.

Dimensionsstabile und sehr gut die Arbeitswärme ableitende Leiterplatten werden üblicherweise dadurch hergestellt, daß man im Kern der Leiterplatte eine relativ dicke Metall-platte anordnet. Dieser Metallkern muß mit Bohrungen versehen sein, um die außen liegenden normalen Leiterzüge durch die Platte hindurch elektrisch verbinden zu können. Zwischen Metallkern und Kupferfolie wird eine Isolierschicht angeordnet, die üblicherweise aus Lackschichten oder glasfaserverstärkten Epoxidharzschichten bestehen kann. Die außen liegenden Leiterzüge werden üblicherweise nach additiver oder subtraktiver Technik aus Kupfer erzeugt.

So beschreibt die DE-OS 27 39 494 ein Basismaterial zur Herstellung von elektrischen Leiterplatten mit einem Trägermaterial aus Metall oder einem Metallkern und einer darauf aufgebrachten Schicht aus einem Isolierstoff, wobei das Trägermaterial bzw. der Metallkern zunächst mit dem erforderlichen Lochmuster versehen wird, worauf die Oberfläche mit einer Schicht aus einem Isoliermaterial überzogen und die Löcher mit dem Isoliermaterial ausgefüllt werden. Dabei wird ein wärmefließfähiges Isoliermaterial, beispielsweise in Form von Prepregs eingesetzt oder ein kupferkaschiertes Epoxidharzglasgewebe aufgebracht und unter Wärme- und Druckeinwirkung verpreßt. Als zu verbessernder Stand der Technik wird in dieser Druckschrift eine Arbeitsweise beschrieben, die darin besteht, die Lochwandungen des Metallträgers im Wirbelsinterverfahren mit einer Isolierschicht zu versehen, auf die dann die Leiterzüge aufgebracht werden. Diese Arbeitsweise wird jedoch als nachteilig beschrieben, indem sie einer aufwendigen Einrichtung und eines komplizierten Verfahrens bedarf und keine befriedigende Ergebnisse liefert, indem die Isolierschicht zu einer sanduhrartigen Form der Lochwandungen führt und unzureichende Isolierschichtdicken an den Lochkanten ergibt. Daher schlägt dieser Stand der Technik die Verwendung von schichtförmigem, wärmefließfähigem Isoliermaterial, wie Epoxidharzprepregs vor.

Gegenstand der DE-OS 30 35 749 sind ebenfalls wärmeableitende Leiterplatten mit einem Kern aus einem metallischen Werkstoff, die als Isolierschicht eine 10 bis 80 µm dicke Galvano-Al-Eloxalschicht aufweisen. Auch diese Druckschrift beschreibt als vorbekannten Stand der Technik eine Methode, gemäß der die Bohrungen der Metallkernplatten mit isolierenden Lackschichten bzw. Kunststoffschichten bedeckt werden, wobei im ersteren Fall die Lackschichten vor allem an den Lochkanten zu dünn sind, kleine Löcher sich mit Lack oder Kunststoff zusetzen und beim Kunststoff-Pulverbeschichten zu dicke Schichten gebildet werden, die sich bei den Löchern trichterförmig statt rechteckig einsenken und sich dadurch insbesondere wegen der schlechten Wärmeleitfähigkeit nachteilig auswirken.

Schließlich beschreibt die DE-OS 35 25 416 ein Verfahren zur Herstellung von gedruckten Schaltungen auf der isolierten Oberfläche von Metallträgerplatten, wobei die Lochinnenwandungen der Metallträgerplatten elektrophoretisch mit einer Harzschicht beschichtet werden, wozu eine Harzlösung verwendet wird, die einen festen Füllstoff enthält.

Diese vorbekannten Methoden zur Herstellung von Basismaterialien für elektrische Leiterplatten mit einem Kern aus einem metallischen Werkstoff vermögen nicht zu befriedigen. Entweder ist die Entlüftung der Bohrlöcher der Metallplatte bei dem Beschichten nicht zuverlässig gewährleistet oder die separate Lochwandisolation wird unzuverlässig. Außerdem ist es schwierig, nur gezielt die Lochwandungen ohne unerwünschte Lackabscheidung an anderen Stellen zu isolieren.

Die Aufgabe der vorliegenden Erfindung besteht nun darin, das Verfahren der eingangs angegebenen Gattung derart zu verbessern, daß es ohne weiteres möglich wird, in einfacher Weise elektrische Leiterplatten mit einem Kern aus einem metallischen Werkstoff zu bilden, die auch im Bereich der Lochwandungen eine homogene Isolierschicht mit gleichmäßiger Schichtdicke aufweisen.

Diese Aufgabe wird nun gelöst durch die kennzeichnenden Merkmale des Verfahrens gemäß Hauptanspruch.

Die Unteransprüche betreffen besonders bevorzugte Ausführungsformen dieses Erfindungsgegenstandes.

Gegenstand der Erfindung ist somit ein Verfahren zur Herstellung von elektrischen Leiterplatten mit einem Kern aus einem metallischen Werkstoff, durch Erzeugen der Isolierschicht auf der mit den erforderlichen Durchgangsbohrungen versehene Metallkernplatte unter Verwendung eines Pulverlacks und Ausbilden der Leiterzüge, welches dadurch gekennzeichnet ist, daß man die Oberfläche der Metallkernplatte vollständig mit einem füllstoffhaltigen Pulverlack unter Ausfüllen der Bohrungen beschichtet, die Pulverlackschicht unter Anhärtung bis zu der B-Stufe aufsintert, auf beiden Seiten der Metallkernplatte eine Metallfolie bei einer Temperatur oberhalb des Schmelzpunkts der Pulverlackschicht unter vollständiger Aushärtung der Pulverlackschicht aufpreßt und anschließend die Leiterzüge in an sich bekannter Weise bildet.

Bei dem erfindungsgemäßen Verfahren geht man von einer Metallkernplatte aus, die mit den erforderlichen Durchgangsbohrungen versehen ist, nämlich mit den notwendigen, zur präzisen Justierung dienenden Positionierungslöchern und Bohrungen zur elektrischen Durchplattierung. Diese Durchgangsbohrungen müssen nicht gebohrt sein, sondern können auch durch Stanzen etc. gebildet sein. Nach dem Entgraten, Entfetten und Aufrauhen der Oberfläche wird die Metallkernplatte vollständig, d.h. auf beiden Seiten mit einem füllstoffhaltigen Pulverlack beschichtet. Dabei werden auch die Bohrungen in der Metallplatte bereits weitgehend ausgefüllt. Wesentlich und abweichend von dem Stand der Technik ist dabei, daß diese Pulverlackschicht nur aufgesintert und bis zu der B-Stufe angehärtet wird. Hierdurch ergeben sich zwei wesentliche Vorteile, nämlich
1. die Durchgangsbohrungen der Metallkernplatte können bei dem sich anschließenden Aufpressen der Metallfolie mit dem geschmolzenen Pulverlack vollständig ausgefüllt werden und
2. die noch fließfähige Pulverlackschicht kann zum Verkleben der aufgepreßten Metallfolie benützt werden.

Die mit der nur aufgesinterten und damit noch voll reaktionsfähigen Pulverlackschicht versehene Metallkernplatte wird auf beiden Seiten mit einer Metallfolie, vorzugsweise einer Kupferfolie noch bevorzugter einer mit einem Epoxidharz beschichteten Kupferfolie belegt, und in einer Presse unter Druck auf eine Temperatur erwärmt, bei der die Pulverlackschicht schmilzt, in die Durchgangsbohrungen der Metallkernplatte fließt und diese ausfüllt, die Oberflächen der Metallkernplatte und der Metallfolie zur Verklebung vollständig benetzt, die eingeschlossene Luft aus der Pulverlackschicht nach Außen transportiert und schließlich vollständig bis zur C-Stufe aushärtet. Dabei bestimmen die Viskosität der geschmolzenen Lackschicht und ihre B-Zeit die Preßtemperatur, den Preßdruck und die Aushärtungszeit.

Die Verwendung von sogenannten Distanzrahmen oder -Drähten erleichtert und verbessert den Preßvorgang, indem der Stapel kalibriert wird und die Lackschichten über die Fläche hinweg gleichmäßig dick ausgebildet werden. Weiterhin ergibt sich eine bessere Toleranzbreite sämtlicher Parameter, die besser zu beherrschen ist. Die erfindungsgemäß eingesetzten Distanzrahmen können beispielsweise aus Leisten aus Hartholz, Schichtpreßstoffabschnitten oder Drähten bestehen, die der angestrebten Plattengröße und -dicke entsprechen, die im Bereich von 0,5 bis 2,5 mm, vorzugsweise zwischen 1,5 und 2,5 mm liegen kann. Die Breite der für den Distanzrahmen verwendeten Leisten kann beispielsweise 25 mm betragen.

Damit das fertige Basismaterial präzise gebohrt werden kann, müssen die Positionierungslöcher, von denen beispielsweise 4 Stück pro Platte vorliegen können, freigelegt werden. Dies kann durch Freifräsen der Metallplatte an den betreffenden Stellen mit Hilfe von Schablonen erfolgen. Wenn verhindert werden soll, daß die Positionierungslöcher beim Preßvorgang mit dem Pulverlack zufließen, müssen sie vor dem Beschichten mit einer wärmbeständigen Klebefolie abgedeckt werden. Nach Freilegen der Positionierungslöcher kann das Basismaterial präzise für das nachfolgende Bohren der zugeflossenen Löcher der Durchgangsbohrungen in der Metallkernplatte eingespannt werden. Dabei werden die neu gebohrten Löcher hinreichend kleiner angelegt als die ursprünglich in der Metallkernplatte vorhandenen Durchgangsbohrungen, damit die Lochwandung vom Metall isoliert bleibt, sofern dies gewünscht wird, und die Metallkernplatte nicht als Bestandteile der elektrischen Schaltung mitverwendet werden soll.

Die Löcher der fertig gebohrten kupferkaschierten Leiterplatten werden dann durchplattiert. Anschließend wird das Leitungsmuster in an sich bekannter Weise durch selektives Abätzen der Metallfolie erzeugt.

Erfindungsgemäß verwendet man vorzugsweise eine Metallkernplatte aus Kupfer, Aluminium, Titan und/oder einer kupferplattierten Nickel-Eisen-Legierung (Invar-Legierung). Dabei besitzt die Metallkernplatte vorzugsweise eine Dicke von 0.1 bis 2 mm.

Erfindungsgemäß kann der Pulverlack durch Wirbelsintern oder durch elektrostatisches Aufsprühen aufgebracht werden, wobei in beiden Fällen die gesamte Oberfläche der Metallkernplatte mit dem füllstoffhaltigen Pulverlack beschichtet wird. Bei dem erfindungsgemäß bevorzugten Wirbelsinterverfahren wird die Dicke der Pulverlackschicht über die Temperatur der Metallkernplatte gesteuert, wobei ganz allgemein gilt, daß die aufgebrachte Schicht um so dicker ist, je höher die Temperatur bzw. die Wärmekapazität der Metallkernplatte ist. Bei elektrostatischer Beschichtung ist die Gewährleistung einer bestimmten Schichtdicke schwieriger, kann jedoch bei Anwendung von Distanzrahmen ohne weiteres erreicht werden.

Das Aufbringen des Pulverlackes durch Wirbelsintern erfolgt vorzugsweise in der Weise, daß die in Abhängigkeit von der Dicke und dem Material auf eine Temperatur von 200 bis 300°C erhitze Metallkernplatte in das durch Druckluft verwirbelte Pulverlackbad eingetaucht wird. Dabei erfolgt die Ausbildung der gewünschten Schicht innerhalb von 6 bis 10 Sekunden Das Aufsintern unter Anhärten bis zu der B-Stufe erfolgt durch Tempern der mit dem Pulverlack beschichteten Metallkernplatte bei einer Temperatur von 100 bis 200°C während einer zum Erreichen der B-Stufe ausreichenden Zeitdauer.

Bei dem erfindungsgemäßen Verfahren verwendet man mit Vorteil einen Pulverlack auf der Grundlage eines Epoxidharzes, insbesondere auf Basis von Bisphenol-A, eines Härters und eines Beschleunigers, welcher Pulverlack 10 bis 50% mindestens eines Füllstoffs und gegebenenfalls Farbstoffe enthält, Mit Vorteil besitzt der Pulverlack einen Schmelzpunkt von 90 bis 100°C und einen Gehalt an Füllstoffen und Farbstoffen von etwa 25%. Als Füllstoffe können insbesondere mineralische Füllstoffe eingesetzt werden, wie Schwerspat, Aluminium-magnesium-silikat und/oder ein Silikatpulver mit niedriger Dielektrizitätskonstante. Der Pulverlack besitzt im Fall des Auftrags durch Wirbelsintern vorzugsweise eine Korngröße von 40 bis 300 µm und im Fall des Auftrags durch elektrostatisches Aufsprühen eine Korngröße von 5 bis 70 µm.

Bei dem erfindungsgemäßen Verfahren verwendet man als Metallfolie, die auf die mit der angehärteten Pulverlackschicht versehene Metallkernplatte aufgebracht wird, vorzugsweise eine Kupferfolie, die insbesondere eine Dicke von 5 bis 105 µm und noch bevorzugter eine Dicke von etwa 35 µm aufweist. Das Aufpressen dieser Metallfolie und das Aushärten der Pulverlackschicht erfolgt insbesondere bei einer Temperatur im Bereich von 150 bis 180°C, insbesondere bei einer Temperatur von 170°C, einem Druck von 2 bis 6 MPa, insbesondere von 4 MPa und einer Zeitdauer von 30 bis 60 Minuten, vorzugsweise von etwa 30 Minuten.

In besonderen Fällen, wenn z.B. die Pulverlackschicht sehr dünn gewählt werden muß, kann man mit Vorteil eine mit Epoxidharz beschichtete Kupferfolie aufpressen, um eine ausreichende Haftung sicherzustellen.

Das erfindungsgemäße Verfahren eignet sich auch für das Aufpressen der Metallfolie nach dem Mass-Lam-Verfahren. Dazu werden z.B. auf einer großflächigen Kupferfolie mehrere mit Pulverlack beschichtete Metallkernplatten nebeneinander angeordnet, so daß die Kupferfolie ganz bedeckt wird. Zwischen die einzelen Platten werden die Distanzleisten gitterartig angeordnet. Diese Anordnung wird mit einer weiteren Kupferfolie abgedeckt und zwischen Preßbleche geschoben. In einer Preßlage können je nach Dicke und Öffnungshöhe zwischen den Heizplatten der Presse viele solcher Anordnungen gestapelt werden, so daß in einer großen Laminatpresse viele hundert solcher beschichteten Metallkernplatten in einem Preßvorgang mit Metallfolie belegt werden können.

Ein weiterer Gegenstand der Erfindung ist ein Basismaterial für elektrische Leiterplatten mit einem Kern aus einem metallischen Werkstoff mit den erforderlichen Durchgangsbohrungen, einer die Oberfläche des Metallkerns bedeckenden Isolierschicht und darauf aufgebrachten Leiterzügen, welches dadurch gekennzeichnet ist, daß die Isolierschicht eine durch Beschichten der Metallkernplatte mit einem füllstoffhaltigen Pulverlack, Anhärten der Pulverlackschicht bis zu der B-Stufe und Aushärten unter Aufpressen einer Metallfolie bei einer Temperatur oberhalb des Schmelzpunkts der Pulverlackschicht erzeugte, auch die Oberflächen der Durchgangsbohrungen der Metallkernplatte bedeckende Isolierschicht ist.

Mit Hilfe des erfindungsgemäßen Verfahrens gelingt es unter Anwendung des füllstoffhaltigen Pulverlackes ohne weiteres eine feste isolierende Verbindung zwischen der Metallkernplatte und der Metallfolie auszubilden. Somit dient bei dem erfindungsgemäßen Verfahren der füllstoffhaltige Pulverlack auf der einen Seite zur Erzeugung einer gleichmäßigen Isolierschicht, die auch die Wandungen der Durchgangsbohrungen und deren Kanten der Metallkernplatte gleichmäßig bedeckt, und auf der anderen Seite als Klebstoff zur festen Fixierung der Metallfolie bzw. der daraus gebildeten Leiterzüge. Dies stellt einen erheblichen Vorteil dar, weil lediglich ein einziges Material verwendet werden muß, welches in einfacher Weise aufgebracht werden kann und nach dem Anhärten bis zu der B-Stufe ohne weiteres gehandhabt und mit einer Metallfolie versehen werden kann. Dabei können aufgrund der Wirbelsintertechnik und des nachfolgenden Preßvorgangs in Verbindung mit dem fließfähigen Pulverlack die bislang offenen Probleme der lufteinschlußfreien Bohrlochausfüllung und Lochhülsenisolation vorteilhaft gelöst werden.

Die folgenden Beispiele dienen der weiteren Erläuterung der Erfindung.

### Beipiel 1

Eine Aluminiumplatte mit den Abmessungen 20 mm x 300 mm x 1,0 mm wird gemäß Schaltungslayout mit 1.5 mm großen Durchgangsbohrungen versehen und dann durch Sandstrahlen auf eine mittlere Rauhtiefe von 15 ± 5 µm aufgerauht. Die für die Positionierung vorgesehenen Fanglöcher werden mit wärmefestem Klebeband abgeklebt. Nach dem Erhitzen auf 250°C wird die Platte während 6 Sekunden in eine Pulverlack-Wirbelschicht getaucht und dabei mit einer Lackschicht von etwa 0,25 mm Dicke abgedeckt, wobei die Löcher größtenteils ausgefüllt werden.

Die Verfahrensparameter können durch Auswiegen der beschichteten Metallkernplatte präzise eingestellt werden.

Der Pulverlack besteht aus 75% Epoxidharz mit einem Erweichungspunkt von 90 bis 100°C und einer Gelierzeit bei 170°C von 70 Sekunden und 25% Schwerspat als Füllstoff. Nach dem Abkühlen auf Raumtemperatur hat die Pulverlackschicht noch eine Gelierzeit von 63 Sekunden. Durch eine Temperung während 3 Minuten bei 120°C wird die Gelierzeit auf ca. 50 bis 55 Sekunden gebracht. Die nunmehr preßfertige Platte wird beidseitig mit einer 35 µm dicken Kupferfolie belegt und unter Anwendung von 1,5 mm dicken Distanzstücken zwischen zwei 2 mm starken, planparallel geschliffenen Edelstahlblechen angeordnet. Das Paket wird dann beidseitig mit einem Papierbogen abgepolstert und zwischen auf 170°C geheizten Preßplatten bei einem Druck von 4 MPa während 30 Minuten verpreßt.

Unter diesen Bedingungen schmilzt der Pulverlack auf, füllt sämtliche Löcher völlig aus, verklebt die Kupferfolie und härtet schließlich aus. Nach dem Abkühlen der Presse kann das fertige Preßlaminat auf Format geschnitten werden Die Metallplatte ist bei richtiger Anordnung der Distanzleisten allseitig mit einer Lackschicht umschlossen, wobei die großflächigen Abdeckschichten etwa 0,2 nun dick und alle Bohrungen zugeflossen sind.

Die zugeklebten Positionierungslöcher werden freigefräst und erlauben dann die präzise Fixierung der Platte auf einem Bohrautomaten. Dort werden dann alle mit Pulverlack ausgefüllten Bohrungen im Metallkern genau in der Mitte so durchbohrt, daß zwischen den Lochwänden der Metallplatte und der zweiten Bohrung eine Hülse aus Pulverlack mit einer Wandstärke von 0.2 mm stehen bleibt. Anschließend werden diese Bohrungen nach bekannten Verfahren durchkontaktiert und die Leitungsmuster beidseitig substraktiv erzeugt.

Man erhält eine sehr dimensionsstabile Leiterplatte, bei der die Isolierschicht im Vergleich zu Glasgewebeschichten eine sehr niedrige Dielektrizitätskonstante aufweist und außerdem eine sehr gute Wärmeableitung bei Verpackungsdichte der Bauelemente gewährleistet.

### Beispiel 2

Man verfährt nach der Arbeitsweise des Beispiels 1, bringt jedoch die Lackschichten durch elektrostatisches Besprühen mit dem Pulverlack auf. In diesem Fall beträgt die erreichbare Dicke der Pulverlackschicht nur maximal 0,1 mm. Weiterhin muß nach dem Auftrag des Pulverlackes eine Wärmebehandlung während 3 Minuten bei 100°C angeschlossen werden, um das Anhärten der Pulverlackschicht bis zu der B-Stufe sicherzustellen. Man erhält nach dem Verpressen eine Leiterplatte mit sehr guten mechanischen und elektrischen Eigenschaften.

Wenn diese Isolierschichtdicke mehr als 0,1 mm betragen soll, müssen die auf beiden Seiten aufgebrachten Kupferfolien mit einer entsprechend dicken Beschichtung aus dem gleichen Pulverlack versehen sein.

## Patentansprüche

1. Verfahren zur Herstellung von elektrischen Leiterplatten mit einem Kern aus einem metallischen Werkstoff, durch Erzeugen der Isolierschicht auf der mit den erforderlichen Durchgangsbohrungen versehenen Metallkernplatte unter Verwendung eines Pulverlacks und Ausbilden der Leiterzüge, **dadurch gekennzeichnet**, daß man die Oberflache der Metallkernplatte vollständig mit einem füllstoffhaltigen Pulverlack unter Ausfüllen der Bohrungen beschichtet, die Pulverlackschicht unter Anhärtung bis zu der B-Stufe aufsintert, auf beiden Seiten der Metallkernplatte eine Metallfolie bei einer Temperatur oberhalb des Schmelzpunkts der Pulverlackschicht unter vollständiger Aushärtung der Pulverlackschicht aufpreßt und anschließend die Leiterzüge in an sich bekannter Weise bildet.

2. Verfahren nach Anspruch 1, **dadurch gekennzeichnet**, daß die Metallkernplatte mit der präzisen Justierung dienenden Positionierungslöchern versehen wird, die gegebenenfalls vor dem Beschichten mit dem füllstoffhaltigen Pulverlack mit einer wärmebeständigen Klebefolie abgedeckt und nach dem Aushärten des Pulverlackes wieder freigelegt werden, wonach die mit dem ausgehärteten Pulverlack ausgefüllten Durchgangsbohrungen der Metallkernplatte unter Zurücklassen einer Isolierschicht auf der Innenwand der Durchgangsbohrungen freigebohrt werden.

3. Verfahren nach Anspruch 1 oder 2, **dadurch gekennzeichnet**, daß man eine Metallkernplatte aus Kupfer, Aluminium, Titan und/oder einer kupferplattierten Nickel-Eisen-Legierung verwendet.

4. Verfahren nach Anspruch 3, **dadurch gekennzeichnet**, daß die Metallkernplatte eine Dicke von 0,1 bis 2 mm aufweist.

5. Verfahren nach Anspruch 1, **dadurch gekennzeichnet**, daß man den Pulverlack durch Wirbelsintern oder elektrostatisches Aufsprühen aufbringt.

6. Verfahren nach Anspruch 1, **dadurch gekennzeichnet**, daß man einen Pulverlack auf der Grundlage eines Epoxidharzes, eines Härters und eines Beschleunigers, der 10 bis 50% mindestens eines Füllstoffs und gegebenenfalls Farbstoffe enthält, einsetzt.

7. Verfahren nach Anspruch 6, **dadurch gekennzeichnet**, daß der Pulverlack einen Schmelzpunkt von 90 bis 100°C aufweist.

8. Verfahren nach Anspruch 6, **dadurch gekennzeichnet**, daß der Pulverlack einen mineralischen Füllstoff enthält.

9. Verfahren nach Anspruch 8, **dadurch gekennzeichnet**, daß der Pulverlack Schwerspat, Aluminium-magnesium-silikat und/oder ein Silikatpulver mit niederiger Dieelektrizitätskonstante als Füllstoff enthält.

10. Verfahren nach Anspruch 6, **dadurch gekennzeichnet**, daß der Pulverlack eine Korngröße von 40 bis 300 µm im Fall des Auftrags durch Wirbelsintern und eine Korngröße von 5 bis 70 µm im Fall des Auftrags durch elektrostatisches Aufsprühen aufweist.

11. Verfahren nach Anspruch 1, **dadurch gekennzeichnet**, daß das Aufsintern des Pulverlacks auf die Metallkernplatte durch Erhitzen der Platte vor dem Beschichten auf eine Temperatur von 200 bis 300°C erreicht wird.

12. Verfahren nach Anspruch 1, **dadurch gekennzeichnet**, daß die mit dem Pulverlack beschichtete Metallkernplatte bei einer Temperatur von 100 bis 200°C getempert wird, bis der gewünschte B-Zustand erreicht ist.

13. Verfahren nach Anspruch 1, **dadurch gekennzeichnet**, daß als Metallfolie eine Kupferfolie, vorzugsweise mit einer Dicke von 5 bis 105 µm eingesetzt wird.

14. Verfahren nach Anspruch 13, **dadurch gekennzeichnet**, daß eine mit einem Epoxidharz beschichtete Kupferfolie verwendet wird.

15. Verfahren nach Anspruch 1, **dadurch gekennzeichnet**, daß man den Anpreßvorgang unter Verwendung von Distanzahmen oder -Drähten bewirkt.

16. Verfahren nach Anspruch 1, **dadurch gekennzeichnet**, daß das Aufpressen der Metallfolie und das Aushärten der Pulverlackschicht bei einer Temperatur im ereich von 150 bis 180°C, einem Druck vpm 2 bis 6 MPa und einer Zeitdauer von 30 bis 60 Minuten erfolgt.

17. Verfahren nach Anspruch 16, **dadurch gekennzeichnet**, daß das Aufpressen der Metallfolie und das Aushärten der Pulverlackschicht bei einer Temperatur von etwa 170°C, einem Druck von etwa 4 MPa und einer Zeitdauer von etwa 30 Minuten erfolgt.

18. Verfahren nach mindestens einem der vorhergehenden Ansprüche, **dadurch gekennzeichnet**, daß das Aufpressen der Metallfolie nach dem Mass-Lam-Verfahren erfolgt, indem eine Vielzahl von mit Pulverlack beschichteten Platten zwischen gemeinsamen größeren Kupferfolien nebeneinander angeordnet und mehrere solcher Gebilde in einem Arbeitsgang gemeinsam verpreßt werden.

19. Verfahren nach Anspruch 18, **dadurch gekennzeichnet**, daß zwischen den einzelnen beschichteten Metallkernen Distanzrahmen oder -Drähte netzförmig angeordnet werden.

## Claims

1. Method for manufacturing electrical circuit boards with a core of metallic material, by producing the insulating layer on the metal core plate provided with the required through drillings, using a powder paint and developing the conductor strips, **characterised** in that by filling-in the drillings the surface of the metal core plate is completely covered with a filler-containing powder paint , during the initial hardening the powder paint is sintered up to the B stage, during complete hardening a metal foil is pressed to both sides of the metal core plate at a temperature which is above the melting point of the powder paint and the conductor strips are then formed in a known manner.

2. Method according to claim 1, **characterised** in that the metal core plate is provided with positioning holes serving for the precise adjustment which, prior to coating with the filler-containing powder paint if necessary are covered with a heat resistant adhesive foil and which holes are opened again after the powder paint has set, whereupon the through drillings of the metal core plate filled with the hardened powder paint are drilled free whilst leaving an insulating layer on the inner wall of the through drillings.

3. Method according to claim 1 or 2, **characterised** in that a metal core plate is used which consists of copper, aluminium, titanium and/or a copper-plated nickel-iron alloy.

4. Method according to claim 3, **characterised** in that the metal core plate has a thickness of 0,1 to 2 mm.

5. Method according to claim 1, **characterised** in that the powder paint is applied by whirl sintering or electrostatic spraying.

6. Method according to claim 1, **characterised** in that a powder paint is used which is based on an epoxide resin, a hardener and an accelerator which contains at least 10% to 50% of a filler and optionally a pigment.

7. Method according to claim 6, **characterised** in that the powder paint has a melting point of 90 to 100°C.

8. Method according to claim 6, **characterised** in that the powder paint contains a mineral filler.

9. Method according to claim 8, **characterised** in that the powder paint contains heavy spar, aluminium magnesium silicate and/or a silicate powder with a low dielectric constant as the filler.

10. Method according to claim 6, **characterised** in that the powder paint has a grain size of 40 to 300µm when applied by whirl sintering and a grain size of 5 to 70µm when applied by electrostatic spraying.

11. Method according to claim 1, **characterised** in that the powder paint is sintered onto the metal core plate by heating the plate prior to coating at a temperature of 200° to 300°C.

12. Method according to claim 1, **characterised** in that the metal core plate coated with the powder paint is tempered at a temperature of from 100 to 200°C until the desired B state is reached.

13. Method according to claim 1, **characterised** in that the metal foil used is a copper foil, preferably having a thickness of 5 to 105µm.

14. Method according to claim 13, **characterised** in that a copper foil coated with epoxide resin is used.

15. Method according to claim 1, **characterised** in that the press-on process is effected by using a spacer frame or wires.

16. Method according to claim 1, **characterised** in that the pressing-on of the metal foil and the hardening of the powder paint is effected at a temperature within the range of 150 to 180°, a pressure of 2 to 6MPa and a period of 30 to 60 minutes.

17. Method according to claim 16, **characterised** in that the pressing-on of the metal foil and the hardening of the powder paint layer is effected at a temperature of approximately 170°C, a pressure of approximately 4 MPa and a period of approximately 30 minutes.

18. Method according to at least one of the preceding claims, **characterised** in that the pressing-on of the metal foil is effected according to the Mass-Lam process, in which a plurality of plates coated with powder paint are arranged side by side between common larger sheets of copper foil and a number of such structures are pressed together in one common work process.

19. Method according to claim 18, **characterised** in that spacer frames or wires are arranged in net-like fashion between the individually coated metal cores.

## Revendications

1. Procédé pour la fabrication de circuits électriques avec un noyau en une substance métallique, consistant à créer une couche isolante sur la plaque de noyau métallique munie des trous traversants nécessaires en utilisant une poudre de laque et en formant des pistes conductrices, caractérisé en ce que l'on recouvre entièrement la face supérieure de la plaque métallique avec une laque en poudre contenant un produit de remplissage, on fritte la couche de laque par durcissement jusqu'au stade B, on applique par pression sur les deux faces de la plaque de noyau métallique une feuille de métal à une température supérieure au point de fusion de la couche de poudre de laque avec durcissement complet de la couche de poudre de laque et, ensuite, on forme les pistes conductrices de manière connue.

2. Procédé selon la revendication 1, caractérisé en ce que la plaque de noyau métallique est munie de trous de positionnement servant à l'ajustement précis, qui sont le cas échéant, avant le dépôt de couche de poudre de laque contenant un produit de remplissage, recouverts d'une feuille adhésive résistant à la chaleur et sont ensuite dégagés après le durcissement de la poudre de laque, après quoi les trous traversants de la plaque de noyau métallique remplis de poudre de laque durcie sont débouchés à nouveau en laissant une couche isolante sur la paroi intérieure des trous traversants.

3. Procédé selon la revendication 1 ou 2, caractérisé en ce que l'on utilise une plaque de noyau métallique en cuivre, aluminium, titane et/ou en un alliage nickel-fer recouvert de cuivre.

4. Procédé selon la revendication 3, caractérisé en ce que la plaque de noyau métallique présente une épaisseur de 0,1 à 2 mm.

5. Procédé selon la revendication 1, caractérisé en ce que l'on dépose la poudre de laque par revêtement en lit fluide ou par projection électrostatique.

6. Procédé selon la revendication 1, caractérisé en ce que l'on applique sur un fond constitué en résine époxy, en durcissant et en accélérateur, qui contient pour 10 à 50 % au moins d'une substance de remplissage et, le cas échéant, des colorants.

7. Procédé selon la revendication 6, caractérisé en ce que la poudre de laque présente un point de fusion de 90 à 100° C.

8. Procédé selon la revendication 6, caractérisé en ce que la poudre de laque contient une substance de remplissage minérale.

9. Procédé selon la revendication 8, caractérisé en ce que la poudre de laque contient comme substance de remplissage de la baryte, du silicate d'aluminium et de magnésium et/ou une poudre de silice avec une constante diélectrique faible.

10. Procédé selon la revendication 6, caractérisé en ce que la poudre de laque présente une dimension de grains de 40 à 300 µm dans le cas de dépôt par revêtement en lit fluide et une dimension de grains de 5 à 70 µm dans le cas de dépôt par projection électrostatique.

11. Procédé selon la revendication 1, caractérisé en ce que le dépôt par frittage de la poudre de laque sur la plaque métallique de noyau est réalisé par chauffage de la plaque, avant le revêtement, à une température de 200 à 300° C.

12. Procédé selon la revendication 1, caractérisé en ce que la plaque métallique de noyau revêtue de la poudre de laque est trempée à une température de 100 à 200° C jusqu'à ce que le stade B souhaité soit atteint.

13. Procédé selon la revendication 1, caractérisé en ce qu'on utilise comme feuille de métal une feuille de cuivre ayant de préférence une épaisseur de 5 à 105 µm.

14. Procédé selon la revendication 13, caractérisé en ce qu'on utilise une feuille de cuivre revêtue d'une résine époxy.

15. Procédé selon la revendication 1, caractérisé en ce que l'on met en oeuvre le processus de pressage en utilisant un cadre ou des fils pour maintenir un espacement.

16. Procédé selon la revendication 1, caractérisé en ce que le pressage de la feuille de métal et le durcissement de la couche de poudre de laque s'effectuent à une température dans la gamme de 150 à 180° C, sous une pression de 2 à 6 MPa et pendant une durée de 30 à 60 minutes.

17. Procédé selon la revendication 16, caractérisé en ce que le pressage de la feuille de métal et le durcissement de la couche de poudre de laque s'effectuent à une température d'environ 170° C, sous une pression d'environ 4 MPa et pendant une durée d'environ 30 minutes.

18. Procédé selon une quelconque au moins des revendications précédentes, caractérisé en ce que le pressage de la feuille de métal s'effectue selon le procédé Mass-Lam dans lequel on dispose, une pluralité de plaques revêtues de poudre de laque l'une à côté de l'autre entre des feuilles de cuivre communes de plus grande dimension, et on presse plusieurs assemblages ainsi réalisés en une seule phase d'usinage.

19. Procédé selon la revendication 18, caractérisé en ce que des cadres ou des fils d'espacement sont disposés en forme de réseau entre les noyaux métalliques individuels revêtus.
